Europäisches Patentamt

European Patent Office

Office européen des brevets

(19)

(11) Veröffentlichungsnummer : **0 130 428**
**B1**

(12) **EUROPÄISCHE PATENTSCHRIFT**

(45) Veröffentlichungstag der Patentschrift :
27.05.87

(51) Int. Cl.⁴ : **G 01 R 13/06, G 01 R 13/34**

(21) Anmeldenummer : 84106821.6

(22) Anmeldetag : 14.06.84

(54) Störungserkennungs- und -aufzeichnungssystem.

(30) Priorität : 24.06.83 DE 3322862

(43) Veröffentlichungstag der Anmeldung :
09.01.85 Patentblatt 85/02

(45) Bekanntmachung des Hinweises auf die Patenterteilung : 27.05.87 Patentblatt 87/22

(84) Benannte Vertragsstaaten :
AT BE CH DE FR GB IT LI NL

(56) Entgegenhaltungen :
GB-A- 2 057 700
GB-A- 2 095 932
US-A- 3 943 349
SIEMENS-ZEITSCHRIFT, Band 45, Heft 10, Oktober
1971, Seiten 634-636; H. KERNER u.a.: "Verzögerungseinheit OSCILLOSTORE zur Störwerterfassung"
SIEMENS-ZEITSCHRIFT, Band 47, Heft 12, Dezember
1973, Seiten 869-872; H. SIMA: "Automatische
Auswertung von Magnetbandaufzeichnungen mit
dem OSCILLOSTORE"

(73) Patentinhaber : **Siemens Aktiengesellschaft Berlin
und München
Wittelsbacherplatz 2
D-8000 München 2 (DE)**

(72) Erfinder : **Hütter, Helmut, Dipl.-Ing.
Hachelallee 16
D-7530 Pforzheim (DE)**
Erfinder : **Maier, Heinz A., Prof. Dr.Ing.
Olgastrasse 15
D-7302 Ostfildern 2 (DE)**

## Beschreibung

Die Erfindung betrifft ein System zum Erkennen und Aufzeichnen von Störungen in periodischen Signalen, die abgetastet, in Digitalwerte umgesetzt und in einen Verzögerungsspeicher eingetragen werden, mit einer Vergleichereinrichtung zum gegenseitigen Vergleichen der Digitalwerte von aufeinanderfolgenden Signalperioden sowie mit mindestens einem störungsgesteuerten Startselektor, der an eine Ausgabeeinrichtung für die verzögerten Signale einen Startimpuls liefert, auf den die Digitalwerte aus dem Verzögerungsspeicher über die Ausgabeeinrichtung weitergeleitet werden.

Ein derartiges System ist in dem Aufsatz « Verzögerungseinheit OSCILLOSTORE zur Störwerterfassung » in der SIEMENS-Zeitschrift 45 (1971), Heft 10, Seiten 634 und 635 beschrieben. Aus den letzten Angaben im Kapitel « Technische Daten einer Sechskanal-Ausführung » des Aufsatzes geht hervor, daß die Einschaltdauer des Registriergerätes 1 bis 10 s beträgt. Diese Einschaltdauer beginnt mit einem Startsignal für einen als Ausgabeeinheit dienenden Schnellschreiber, das ein Startselektor, beispielsweise eine du/dt-Anregung, abgibt. Die Einschaltdauer ist unabhängig von der Dauer der Störung, die aufgezeichnet werden soll. Allenfalls kann die Einschaltdauer nach Erfahrungswerten festgelegt werden. Es ist jedoch zu erwarten, daß die wirkliche Dauer einer Störung oft die eingestellte Einschaltdauer überschreitet oder nicht erreicht, so daß entweder wertvolle Information verlorengeht und im anderen Falle zusätzlich für nicht interessierende Normalzustände Registriermaterial verbraucht wird.

In einem Aufsatz « Automatische Auswertung von Magnetbandaufzeichnungen mit dem OSCILLOSTORE » aus der SIEMENS-Zeitschrift 47 (1973), Heft 12, Seiten 869 bis 872 ist unter der Kapitelüberschrift « Konventionelle Meßtechnik-Programmiertes Messen » ausgeführt, daß, sobald die Meßdaten wieder einen ungestörten Verlauf aufweisen, die zum Erfassen der Störung vorgesehenen Diskriminatoren das Ausgabegerät wieder abschalten. Diese Methode schließt zwar aus, daß infolge einer zu kurzen Einschaltdauer interessierende Daten einer Störung nicht aufgezeichnet werden, sie vermeidet jedoch nicht eine Aufzeichnung von unwichtigen Daten einer stationär gewordenen Störung und damit eine Verschwendung von Registriermaterial.

In der GB-A-2 057 700 ist ein System beschrieben, bei dem ein Eingangssignal von einer Abtastimpulsfolge abgetastet und in digitale Signalwerte umgesetzt wird. In einem digitalen Vergleicher werden sie mit Minimal- bzw. Maximalwerten verglichen und mit einer Frequenz in einen Signalformspeicher eingetragen, die niedriger ist als die Abtastfrequenz. Dadurch lassen sich Spitzen des Eingangssignals erfassen, auch wenn deren Dauer kleiner ist als die Periodendauer der Schreibimpulse für den Signalformspeicher.

Der Erfindung lag die Aufgabe zugrunde, alle Übergangszustände zu erfassen, jedoch keine Daten aufzunehmen, die sich aus schon aufgezeichneten Daten rekonstruieren lassen.

Die Erfindung folgte dabei der Erkenntnis, daß nur die transitären oder Übergangszustände aufgezeichnet werden sollen, und zwar auch solche transitären Zustände, die eine stationär gewordene Störung in einen stationären Normalbetriebszustand überleiten. Stationäre Zustände selbst, seien sie normale Betriebszustände oder stationär gewordene Störungszustände, sollen jedoch nicht aufgezeichnet oder ausgegeben werden, weil sie jederzeit aus der ersten oder zweiten Periode des stationären Zustandes rekonstruiert werden können.

Gemäß der Erfindung wird die oben angegebene Aufgabe bei einem eingangs beschriebenen System dadurch gelöst, daß die mit einer Abtastimpulsfolge abgetasteten digitalen Signalwerte in einem Schreib-/Lesespeicher signalperiodenweise zwischengespeichert sowie die Abtastimpulse signalperiodenweise in einem Zähler gezählt sind und die Anzahl der für eine vorausgegangene Signalperiode gezählten Abtastimpulse in einem Register (Ausgang des Zählers 6) festgehalten ist und daß dieser Registerinhalt über eine Adreßsteuerung die Adressen derjenigen im Schreib-/Lesespeicher zwischengespeicherten Signalwerte bestimmt, die zusammen mit entsprechenden Signalwerten einer der zwischengespeicherten Signalperioden unmittelbar folgenden Signalperiode einem digitalen Vergleicher zugeführt sind, der je nach Nichtübereinstimmung oder Übereinstimmung der miteinander verglichenen Signalwerte ein Start- bzw. Stoppsignal an die Ausgabeeinrichtung für den Verzögerungsspeicher liefert.

Der digitale Vergleicher stellt fest, ob die momentan einlaufende Signalperiode einem stationären oder transitären Zustand angehört, und steuert dementsprechend die Ausgabeeinrichtung für die im Verzögerungsspeicher gespeicherten digitalen Signalwerte.

Der periodenweise Momentanwertvergleich findet nach einer selbsttätigen Abstimmung der Vergleichsoperation auf die Grundfrequenz des analogen Eingangssignals statt. Dies ist zweckmäßig, weil die Periodendauer der Grundschwingung des periodischen Signals in der Regel nicht konstant ist. Deshalb berücksichtigt die Adreßsteuerung des Schreib-/Lesespeichers (RAM) die Periodendauer bei der Vergleichsoperation. Dies geschieht unter gleichzeitigem Zählen der auf je eine Periode des periodischen Eingangssignals entfallenden Abtastimpulse. Zusätzlich ergibt sich dadurch die Möglichkeit, die Frequenz des Eingangssignals zu überwachen und bei einer Änderung als Zahl aufzuzeichnen.

Mit Vorteil ist im Signalweg zwischen dem Schreib-/Lesespeicher und dem Verzögerungsspeicher eine von den Ausgangssignalen des digitalen Vergleichers gesteuerte Schaltung zur zeitlichen Verdichtung der zu verzögernden Signale eingefügt. Der Verdichtungsfaktor ist über einen Codierschalter vorwählbar, beispielsweise in den Verhältnissen 1 : 4, 1 : 8, 1 : 16 und 1 : 32. Diese Verhältnisse sind nur als Beispiele angeführt, es sind auch jederzeit andere Verdichtungsverhältnisse ausführbar.

Ein weiterer Schritt zur Datenreduktion liegt in der Unterteilung der transitären Vorgänge in Bereiche mit hochfrequenten Anteilen im Eingangssignal und Bereiche, in denen das Eingangssignal betriebsfrequent ist, seine Amplitude sich jedoch noch ändert. In den letztgenannten Bereichen kann eine Verringerung der Aufzeichnungsrate stattfinden, ohne daß hierdurch Informationen verlorengehen. Um in diesen Bereichen eine Datenreduktion durchzuführen, wird die Toleranzschwelle der Differenz der im digitalen Vergleicher miteinander verglichenen Signalwerte etwas angehoben und zusätzlich eine periodenweise Amplitudenüberwachung durchgeführt. Mit Vorteil findet neben dem periodenweisen Vergleich der Momentanwerte des Signals zusätzlich in einer Amplitudenüberwachungseinheit eine Überwachung seiner Amplitude auf nichttransitäre kleine Änderungen statt. Treten derartige Änderungen auf, so wird nur mit verminderter Aufzeichnungsrate aufgezeichnet.

Die Erfindung wird anhand einer Figur, die ein Blockschaltbild eines Ausführungsbeispiels darstellt, näher erläutert. Einzelne Einheiten des gesamten Systems sind in strichpunktiert umrandete Blöcke 1 bis 5 zusammengefaßt. Block 1 enthält die der Signalvorverarbeitung dienenden Einheiten. Block 2 dient der Amplitudenüberwachung und der zugehörigen Aufzeichnungssteuerung. Block 3 enthält Einheiten für den periodenweisen Momentanwertvergleich und der dazugehörigen Aufzeichnungssteuerung sowie den Datentransport und den Verzögerungsspeicher. Block 4 enthält eine Frequenzüberwachungsschaltung, und in Block 5 sind die Datenausgabe und eine Echtzeituhr zusammengefaßt.

Block 1 enthält als Eingangsschaltung für das zu überwachende Analogsignal ein Antialiasing-Filter 1. Der Ausgang dieses Filters ist mit dem Eingang eines Analog-Digital-Umsetzers 2 verbunden, der einen nicht näher dargestellten Abtaster (Sample/Hold-Schaltung) enthält. Weiter ist der Ausgang des Filters 1 an den Eingang eines Bandpasses 3 gelegt, dessen Mittenfrequenz der Betriebsfrequenz des analogen Eingangssignals entspricht. Der Ausgang des Bandpasses 3 liegt am Eingang eines Komparators 4, der ein Taktsignal für die mit der Grundschwingung des Eingangssignals synchron durchzuführenden Operationen des Systems abgibt. Dazu sind seine Ausgangssignale an eine im Block 2 befindliche Amplitudenüberwachungsschaltung 5 gelegt und außerdem einem Zähler 6 innerhalb des Blockes 3 zugeführt. Im Zähler 6 steuern sie Anfang und Ende einer Zählperiode für Abtastimpulse aus einem Impulsgenerator TG, die außerdem dem Analog-Digital-Umsetzer 2 und einer Adreßsteuerung 8 eingegeben werden. Die abgetasteten und im Analog-Digital-Umsetzer 2 anfallenden Digitalwerte sind an den Eingang eines Schreib-/Lesespeichers (RAM) 7 geführt, in dem immer mindestens eine volle Periode des Eingangssignals zwischengespeichert wird. Die zusätzlich mit dem Inhalt eines Ausgangsregisters des Zählers 6 beschickte Adreßsteuerung 8 ist mit ihrem Ausgang an die Adreßeingänge des Schreib-/Lesespeichers (RAM) 7 angeschlossen. Die Adreßsteuerung 8 hat zunächst die Aufgabe, den Schreib-/Lesespeicher (RAM) 7 fortlaufend von Anfang bis Ende durchzuadressieren. Diese Adressierung ist vergleichbar mit einem Zeiger, der wie bei einer Uhr ringförmig angeordnete Speicherzellen nacheinander anspricht. Diese Betriebsweise wird durch einen in der Adreßsteuerung 8 enthaltenen Adreßzähler modulo RAM-Länge bewirkt, was bedeutet, daß der Adreßzähler immer dann, wenn er die letzte Schreib-/Lesespeicherzelle adressiert hat, wieder bei der ersten anfängt. Das R/W (Read/Write)-Signal der Adreßsteuerung 8 hat auch die Aufgabe, immer dann, wenn der Adreßzähler um Eins weitergezählt wurde, den Inhalt der mit dem ältesten Abtastwert geladenen Schreib-/Lesespeicherzelle an den zeitlichen Verdichter 9 auszulesen und mit dem nächsten Takt den zuletzt vom Analog-Digital-Umsetzer 2 bereitgestellten Wert in die gleiche Zelle einzuschreiben. Die Adreßsteuerung liest also immer den ältesten zwischengespeicherten Momentanwert aus dem Schreib-/Lesespeicher (RAM) 7 aus und schreibt den jüngsten Momentanwert in den gleichen Speicher ein. Der bisher beschriebene Teil des Blockes 3 stellt demnach eine Art Schieberegister dar, das so lang ist, daß es mindestens eine Grundschwingungsperiode des analogen Eingangssignals aufnehmen kann. Der vom Analog-Digital-Umsetzer 2 gelieferte und in den Schreib-/Lesespeicher (RAM) 7 eingetragene Momentanwert wird gleichzeitig in einem in einem digitalen Vergleicher 10 enthaltenen Register zwischengespeichert.

Außerdem ermittelt die Adreßsteuerung 8 die Adresse, in der der für eine Vergleichsoperation benötigte Abtastwert der vorausgegangenen Periode im Schreib-/Lesespeicher (RAM) 7 steht. Hierzu dient ihr die Information, die in dem Ausgangsregister des Zählerbausteins 6 abgelegt ist. Dieser Zähler zählt andauernd die Zahl der Abtastungen, die während einer Periode der Grundschwingung des analogen Eingangssignals getätigt werden. Für Anfang und Ende seiner Zählung bedient er sich des mit der Grundschwingung des periodischen Eingangssignals synchron laufenden Rechtecksignals des Komparators 4. Die festgestellte Zahl der Abtastungen wird immer für die Dauer einer Periode in dem erwähnten Ausgangsregister des Zählers 6 festgehalten. Diesen Wert, der die Zahl der Abtastungen in der Vorperiode angibt, subtrahiert die Adreßsteuerung 8 vom momentanen Adreßzählerwert und erhält damit die Adresse der Schreib-/Lesespeicherzelle, in der der für die Vergleichsoperation benötigte Abtastwert der Vorperiode steht. Mittels des R/W-Signales bewirkt die Adreßsteuerung 8 die Übernahme des Vorperiodenwertes aus dem Schreib-/Lesespeicher (RAM) 7 in ein zweites Register des digitalen Vergleichers 10. Im digitalen Zahlenvergleicher 10 werden im Schreib-/Lesespeicher (RAM) 7 abgespeicherte Digitalwerte einer vorhergehenden Signalperiode mit den Digitalwerten einer folgenden Periode verglichen. Eine eventuell vorliegende Differenz wird an einer Toleranzschwelle gemessen. Bei Überschreiten der Toleranzschwelle wird eine Aufzeichnungssteuerung 11, die ein Teil des Vergleichers 10 ist, betätigt.

Der Datenausgang des Schreib-/Lesespeichers (RAM) 7 ist außerdem mit einer zeitlichen Verdichtungsschaltung 9 verbunden, die während eines stationären Zustandes des analogen Eingangssignals nur jeden n-ten Momentanwert aus dem Schreib-/Lesespeicher (RAM) 7 an einen Verzögerungsspeicher FIFO weiterleitet. Zwei Ausgänge der Aufzeichnungssteuerung 11 sind mit zwei Eingängen der zeitlichen Verdichtungsschaltung 9 verbunden. Dabei liegt der entsprechend gekennzeichnete Stoppausgang der Aufzeichnungssteuerung 11 an einem die zeitliche Verdichtung bewirkenden Eingang und ihr Startausgang an einem die zeitliche Verdichtung aufhebenden Eingang der Verdichtungsschaltung 9. Der Stoppausgang der Aufzeichnungssteuerung 11 liegt auch am Eingang eines dem Block 2 angehörenden Aufzeichnungssteuerungsaggregates 12, das noch von der Amplitudenüberwachung 5 beaufschlagt wird. Stopp- und Startsignalausgang des Aufzeichnungssteuerungsaggregates 12 sind mit entsprechenden Eingängen eines im Block 5 liegenden Ausgabe-Einrichtung 13 verbunden, die im Ausführungsbeispiel ein Register ist. Die Einheit 13 gibt jeweils am Ausgang des Verzögerungsspeichers FIFO liegende Zahlenwerte in Form von einer On-Line-Aufzeichnung an einen Datenspeicher bzw. Drucker 14 weiter. Wird im digitalen Zahlenvergleicher 10 während mindestens einer Periode des analogen Eingangssignals kein Überschreiten der Toleranzschwelle festgestellt, so schaltet die Steuerung die zeitliche Verdichtungsschaltung 9 wieder an und startet das Aufzeichnungssteuerungsaggregat 12, das mit der Amplitudenüberwachung verbunden ist, um den Verzögerungsspeicher FIFO zweimal zu entleeren.

Die beschriebene Schaltung hat die Wirkung, daß einige Perioden zeitlich verdichteter Momentanwerte und eine Periode mit jedem Wert eines vorhergehenden stationären Betriebs, der Übergangsvorgang selbst und eine Periode des neuen stationären Betriebs und einige weitere zeitlich verdichtete Perioden aufgezeichnet werden. Ein externer Triggereingang 15 hat die gleiche Wirkung wie das Überschreiten der Toleranzschwelle beim Vergleich.

Stellt die Amplitudenüberwachung 5 eine betriebsfrequente Amplitudenänderung fest, so werden nur einige verdichtete Perioden vor und nach dem Ansprechen der Amplitudenüberwachung 5 aufgezeichnet.

Auch bei einem satten Kurzschluß des analogen Eingangssignals (Nullsignal) tritt keine Fehlfunktion der Schaltung auf, weil der Zustand im Ausgangsregister des Zählers 6 erhalten bleibt (der Komparator 4 liefert kein Signal). Die durch den Kurzschluß begonnene Aufzeichnung wird also wie bei jedem anderen Übergang in einen stationären Betriebszustand abgeschaltet, sobald für mindestens eine Periode der zuletzt festgestellten Periodendauer der Grundschwingung des Eingangssignals bei der Vergleichsoperation keine die Toleranzschwelle überschreitende Differenz festgestellt worden ist.

Die im Block 4 enthaltene Frequenzüberwachung 16 veranlaßt ein besonderes, dafür vorgesehenes Latch 17 zur Ausgabe eines Frequenzwertes bei einer Frequenzänderung. Vor Beginn jeder Aufzeichnung wird die aus einer Echtzeituhr 18 in einem weiteren Latch 19 gespeicherte Echtzeit ausgegeben.

Bei der Ansteuerung der Aufzeichnung sind Prioritäten festgelegt. Die erste Priorität hat der periodenweise Momentanwertvergleich, die zweite Priorität hat die Amplitudenüberwachung und die dritte Priorität die Frequenzüberwachung. Dabei ist vorgesehen, bei nur langsamen Änderungen der Grundfrequenz des analogen Eingangssignals nur diesen Frequenzwert aufzuzeichnen.

Ein- und Ausschaltvorgänge überwachter analoger Eingangssignale werden wie andere Übergänge zwischen zwei stationären Betriebszuständen behandelt.

Es versteht sich, daß das vorgeschlagene System durch einen Multiplexer am Eingang und einen Demultiplexer am Ausgang mehrkanalig aufgebaut werden kann.

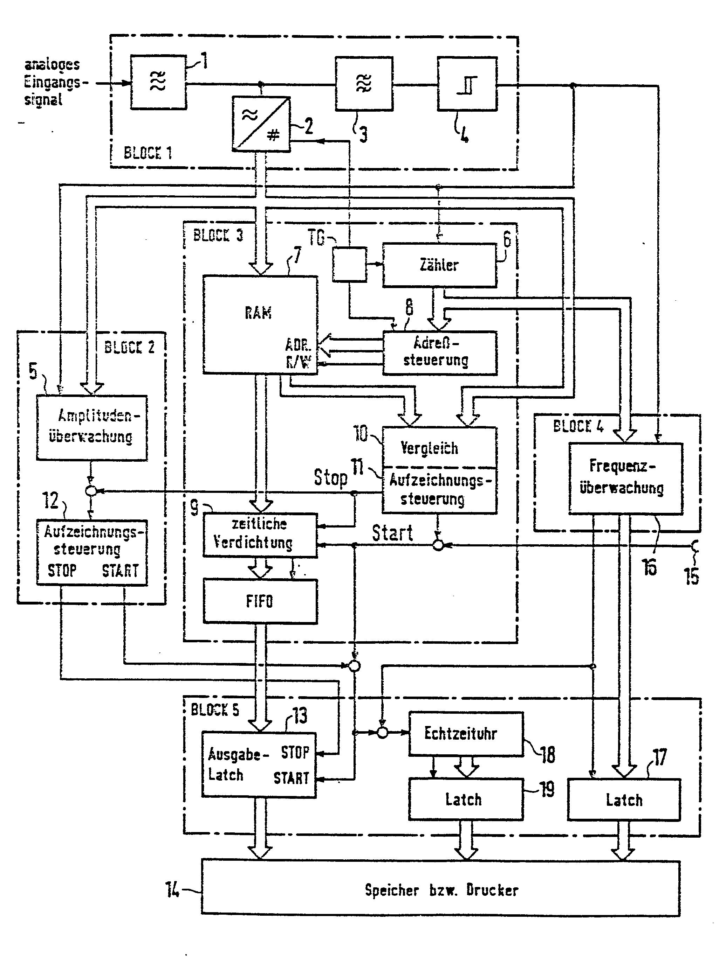

**Patentansprüche**

1. System zum Erkennen und Aufzeichnen von Störungen in periodischen Signalen, die abgetastet, in Digitalwerte (2) umgesetzt und in einen Verzögerungsspeicher (FIFO) eingetragen werden, mit einer Vergleichereinrichtung (10) zum gegenseitigen Vergleichen der Digitalwerte von aufeinanderfolgenden Signalperioden sowie mit mindestens einem störungsgesteuerten Startselektor (11), der an eine Ausgabeeinrichtung (13) für die verzögerten Signale einen Startimpuls liefert, auf den die Digitalwerte aus dem Verzögerungsspeicher (FIFO) über die Ausgabeeinrichtung (13) weitergeleitet werden, dadurch gekennzeichnet, daß die mit einer Abtastimpulsfolge abgetasteten digitalen Signalwerte in einem Schreib-/Lesespeicher (7) signalperiodenweise zwischengespeichert sowie die Abtastimpulse signalperiodenweise in einem Zähler (6) gezählt sind und die Anzahl der für eine vorausgegangene Signalperiode gezählten Abtastimpulse in einem Register (Ausgang des Zählers 6) festgehalten ist und daß dieser Registerinhalt über eine Adreßsteuerung (8) die Adressen derjenigen im Schreib-/Lesespeicher (7) zwischengespeicherten Signalwerte bestimmt, die zusammen mit entsprechenden Signalwerten einer der zwischengespeicherten Signalperiode unmittelbar folgenden Signalperiode einem digitalen Vergleicher (10) zugeführt sind, der je nach Nichtübereinstimmung oder Übereinstimmung der miteinander verglichenen Signalwerte ein Start- bzw. Stoppsignal an die Ausgabeeinrichtung (13) für den Verzögerungsspeicher (FIFO) liefert.

2. Störungserkennungs- und -aufzeichnungssystem nach Anspruch 1, dadurch gekennzeichnet, daß zwischen Schreib-/Lesespeicher (RAM) (7) und Verzögerungsspeicher (FIFO) eine von den Ausgangssignalen des digitalen Vergleichers (10) gesteuerte zeitliche Verdichtungsschaltung (9) liegt.

3. Störungserkennungs- und -aufzeichnungssystem nach Anspruch 1 oder 2, dadurch gekennzeichnet, daß neben dem periodenweisen Vergleich der Momentanwerte des Signals zusätzlich in einer Amplitudenüberwachungseinheit (5) eine Überwachung seiner Amplitude auf nichttransitäre Kleine Änderungen stattfindet, wobei im vorliegenden Fall mit einer verminderten Aufzeichnungsrate aufgezeichnet wird.

## Claims

1. A system for recognising and recording disturbances in periodic signals which are sampled, converted into digital values (2) and input into a delay store (FIFO), with a comparator device (10) which compares the digital values of consecutive signal periods with one another, and with at least one disturbance-controlled start selector (11) which supplies an output device (13) for the delayed signals with a start pulse in response to which the digital signals are fed from the delay store (FIFO) to the output device (13), characterised in that the digital signal values which are sampled with a sampling pulse sequence are intermediately stored signal-period-wise in a write/read store (7), the sampling pulses are counted signal-period-wise in a counter (6), and the number of sampling pulses counted for a previous signal period is stored in a register (output of the counter 6), and that via an address control unit (8) this register content determines the addresses of those signal values which are intermediately stored in the write/read store (7) and which, together with corresponding signal values of a signal period which directly follows the intermediately-stored signal period, are fed to a digital comparator (10) which, depending upon the non-identity or identity of the mutually compared signal values, emits a start- or a stop signal respectively to the output device (13) for the delay store (FIFO).

2. An interference recognition- and recording system as claimed in claim 1, characterised in that a time compression circuit (9), controlled by the output signals of the digital comparator (10), is arranged between the write/read store (RAM) (7) and the delay store (FIFO).

3. A disturbance recognition- and recording system as claimed in claim 1 or 2, characterised in that in addition to the period-wise comparison of the instantaneous values of the signal, in addition its amplitude is monitored in an amplitude monitoring unit (5) to establish non-transitory, small changes, and if such changes occur a reduced recording rate is used.

## Revendications

1. Système pour identifier et représenter des perturbations dans des signaux périodiques, qui sont explorés, convertis en valeurs numériques (2) et insérés dans une mémoire à ligne à retard (FIFO) et comportant un dispositif comparateur (10) servant à comparer mutuellement les valeurs numériques de périodes successives des signaux ainsi qu'au moins un sélecteur de démarrage (11) commandé par la perturbation et qui envoie à un dispositif (13) d'autorisation pour les signaux retardés, une impulsion de démarrage lors de laquelle les valeurs numériques sont retransmises à partir de la mémoire à ligne à retard (FIFO), par l'intermédiaire du dispositif de sortie (13), caractérisé par le fait que les valeurs numériques des signaux, explorés avec une suite d'impulsions d'exploration, sont mémorisées temporairement, pour chaque période des signaux, dans une mémoire d'enregistrement/lecture (7), et les impulsions d'exploration sont comptées pour les différentes périodes des signaux, dans un compteur (6) et le nombre des impulsions d'exploration, compté pour une période antérieure des signaux, est conservé dans un registre (sortie du compteur 6) et que ce contenu du registre détermine au moyen d'un dispositif de commande d'adresses (8) les adresses des valeurs de signaux, mémorisées temporairement dans la mémoire d'enregistrement/lecture (7) et qui sont envoyées, ainsi que les valeurs correspondantes des signaux, intervenant pendant une période des signaux succédant directement à la période des signaux, pendant laquelle s'est effectuée la mémorisation temporaire à un comparateur numérique (10) qui, en fonction de la non coïncidence ou de la coïncidence des valeurs de signaux comparées entre elles, envoie un signal de démarrage ou un signal d'arrêt au dispositif de sortie (13) pour la mémoire ligne à retard (FIFO).

2. Système d'identification et d'enregistrement de perturbations suivant la revendication 1, caractérisé par le fait qu'entre la mémoire d'enregistrement/lecture (RAM) (7) et la mémoire à ligne à retard (FIFO) se trouve disposé un circuit de compression temporelle (9) commandé par les signaux de sortie du comparateur numérique (10).

3. Système d'identification et d'enregistrement de perturbations suivant la revendication 1 ou 2, caractérisé par le fait qu'en dehors de la comparaison, période par période, des valeurs instantanées du signal, il se produit en outre, dans une unité (5) de contrôle d'amplitude, un contrôle de l'amplitude du signal pour savoir s'il ne comporte pas de petites variations non transistoires, l'enregistrement étant réalisé dans le cas présent avec une vitesse réduite d'enregistrement.